# EUROPEAN PATENT APPLICATION

(11) **EP 3 252 807 A1**
(43) Date of publication of application: **06.12.2017**
(21) Application number: 16743190.7
(22) Date of filing: 20.01.2016
(51) Int. Cl.: H01L 23/02, H01L 23/06, H03H 9/02

(54) **COVER MATERIAL FOR HERMETIC SEALING AND ELECTRONIC COMPONENT-CONTAINING PACKAGE**

(30) Priority: 29.01.2015 JP 2015015406
(71) Applicant: Hitachi Metals, Ltd., Tokyo 108-8224 (JP)
(72) Inventor: YOKOTA, Masayuki, Suita-shi Osaka 564-0043 (JP); YAMAMOTO, Masaharu, Suita-shi Osaka 564-0043 (JP)
(74) Representative: Hoffmann Eitle
(86) International application number: PCT/JP2016/051511
(87) International publication number: WO 2016/121586

(57) **Abstract**

This hermetic sealing lid member (1) is made of a clad material (10) including a base material layer (11) made of an Fe alloy that contains 4 mass% or more of Cr and a silver brazing layer (13) bonded onto a surface of the base material layer on a side closer to an electronic component housing member through an intermediate layer (12).

## Description

### Technical Field

The present invention relates to a hermetic sealing lid member and an electronic component housing package using the same.

### Background Art

A hermetic sealing lid member used for an electronic component housing package is known in general. Such a hermetic sealing lid member is disclosed in Japanese Patent No. 3850787, for example.

Japanese Patent No. 3850787 discloses a lid member directly braze-bonded to a case made of ceramics without using a seal ring. This lid member is made of a clad material in which a base material layer made of kovar (registered trademark), an intermediate metal layer directly made of Cu and directly bonded to a surface of the base material layer, and a brazing material layer made of a silver brazing alloy and directly bonded to a surface of the intermediate metal layer on a side opposite to the base material layer are bonded to each other. In the lid member, side surfaces of the intermediate metal layer and the base material layer and the silver brazing layer are exposed outward.

### Prior Art Document

### Patent Document

Patent Document 1: Japanese Patent No. 3850787

### Summary of the Invention

### Problem to be Solved by the Invention

However, in the lid member disclosed in Japanese Patent No. 3850787, although there are no particular problems in the intermediate metal layer made of Cu and the brazing material layer made of the silver brazing alloy, the base material layer is made of kovar having a low corrosion resistance while side surfaces of the lid member are exposed outward, and hence there is such a problem that the base material layer may corrode in a harsh environment such as a location where the lid member comes in contact with salt water (seawater). In this case, the hermetic sealability of an electronic component housing package using the case and the lid member may be reduced.

The present invention has been proposed in order to solve the aforementioned problem, and an object of the present invention is to provide a hermetic sealing lid member capable of being directly braze-bonded to an electronic component housing member without using a seal ring, in which the corrosion of a base material layer can be suppressed, and an electronic component housing package using the hermetic sealing lid member.

### Means for Solving the Problem

A hermetic sealing lid member according to a first aspect of the present invention is a hermetic sealing lid member used for an electronic component housing package including an electronic component housing member for housing an electronic component, and is made of a clad material including a base material layer made of an Fe alloy that contains 4 mass% or more of Cr and a silver brazing layer bonded onto one surface of the base material layer on a side closer to the electronic component housing member through an intermediate layer made of Cu or bonded in direct contact with the surface of the base material layer on the side closer to the electronic component housing member.

In the hermetic sealing lid member according to the first aspect of the present invention, as hereinabove described, the base material layer is made of the Fe alloy that contains 4 mass% or more of Cr such that the corrosion resistance of the base material layer can be reliably improved, and hence the corrosion of the base material layer can be suppressed even in a harsh environment. This has been confirmed by an experiment. Thus, the degradation of the hermetic sealing lid member caused by the corrosion can be suppressed, and hence a reduction in the hermetic sealability of the electronic component housing package using the hermetic sealing lid member can be suppressed. Furthermore, the hermetic sealing lid member can be directly braze-bonded to the electronic component housing member without using a seal ring by the silver brazing layer bonded onto one surface of the base material layer on the side closer to the electronic component housing member through the intermediate layer made of Cu or bonded in direct contact with one surface of the base material layer on the side closer to the electronic component housing member.

In the aforementioned hermetic sealing lid member according to the first aspect, the base material layer is preferably made of the Fe alloy that contains 4 mass% or more and 20 mass% or less of Cr. According to this structure, an increase in the thermal expansion coefficient of the base material layer caused by an increase in the content percentage of Cr over about 20 mass% can be suppressed. Thus, an increase in a difference in thermal expansion between the electronic component housing member made of a low thermal expansion material such as ceramics and the hermetic sealing lid member can be suppressed. Consequently, a thermal stress generated between the hermetic sealing lid member and the electronic component housing member can be reduced, and hence a reduction in the hermetic sealability of the electronic component housing package caused by the thermal stress can be suppressed.

In this case, the base material layer is preferably made of the Fe alloy that contains 6 mass% or more and 10 mass% or less of Cr. According to this structure, the corrosion resistance of the base material layer can be reliably improved by setting the content percentage of Cr of the base material layer to 6 mass% or more. Furthermore, an increase in the thermal expansion coefficient of the base material layer can be effectively suppressed by setting the content percentage of Cr of the base material layer to 10 mass% or less.

In the aforementioned hermetic sealing lid member according to the first aspect, the base material layer is preferably made of the Fe alloy that further contains Ni in addition to 4 mass% or more of Cr. According to this structure, an increase in the thermal expansion coefficient of the base material layer can be suppressed by containing Ni in the Fe alloy of the base material layer while the sufficient corrosion resistance of the base material layer is ensured by setting the content percentage of Cr of the base material layer to 4 mass% or more.

In this case, the base material layer is preferably made of the Fe alloy that further contains 36 mass% or more and 48 mass% or less of Ni in addition to 4 mass% or more of Cr. The base material layer is more preferably made of the Fe alloy that further contains 40 mass% or more and 48 mass% or less of Ni in addition to 4 mass% or more of Cr. According to this structure, an increase in the thermal expansion coefficient of the base material layer can be effectively suppressed by setting the content percentage of Ni of the base material layer to 36 mass% or more and 48 mass% or less (more preferably 40 mass% or more and 48 mass% or less) while the sufficient corrosion resistance of the base material layer is ensured by setting the content percentage of Cr of the base material layer to 4 mass% or more.

In the aforementioned structure in which the base material layer is made of the Fe alloy that contains Ni in addition to Cr, the base material layer is preferably made of the Fe alloy that further contains Co in addition to 4 mass% or more of Cr and Ni. According to this structure, an increase in the thermal expansion coefficient of the base material layer can be effectively suppressed by containing not only Ni but also Co in the Fe alloy of which the base material layer is made.

In this case, the base material layer is preferably made of the Fe alloy that further contains 6 mass% or more and 18 mass% or less of Co in addition to 4 mass% or more of Cr and 36 mass% or more and 48 mass% or less of Ni. According to this structure, an increase in the thermal expansion coefficient of the base material layer can be more effectively suppressed.

In the aforementioned hermetic sealing lid member according to the first aspect, the base material layer is preferably made of a Cr-Fe alloy that contains neither Ni nor Co and at least contains 16 mass% or more and 20 mass% or less of Cr. According to this structure, the corrosion resistance of the base material layer can be more reliably ensured, and the thermal expansion of the base material layer can be effectively suppressed when the hermetic sealing lid member is arranged in a high-temperature environment of 400°C or more, for example.

In the aforementioned hermetic sealing lid member according to the first aspect, the silver brazing layer is preferably bonded to the base material layer through the intermediate layer made of pure Cu that contains 99.95 mass% or more of Cu. According to this structure, the intermediate layer can be sufficiently softened, and hence the thermal stress caused by the difference in thermal expansion between the hermetic sealing lid member and the electronic component housing member can be sufficiently relieved by the soft intermediate layer.

In the aforementioned hermetic sealing lid member according to the first aspect, a thickness of the intermediate layer is preferably 5 µm or more and 50 µm or less. The thickness of the intermediate layer is more preferably 10 µm or more and 30 µm or less. According to this structure, the thickness of the intermediate layer can be sufficiently ensured by setting the thickness of the intermediate layer to 5 µm or more (more preferably 10 µm or more), and hence the thermal stress caused by the difference in thermal expansion between the hermetic sealing lid member and the electronic component housing member can be sufficiently relieved. Furthermore, the thickness of the intermediate layer is about 50 µm or less (more preferably about 30 µm or less) such that the formation of an excessive amount of the intermediate layer can be suppressed, and hence an increase in the size of the hermetic sealing lid member in a thickness direction can be suppressed.

In the aforementioned hermetic sealing lid member according to the first aspect, the silver brazing layer preferably contains Ag and Cu. According to this structure, the melting point of the silver brazing layer can be reduced, and hence in a state where the temperature rising of the hermetic sealing lid member and the temperature rising of the electronic component housing member are suppressed at the time of braze bonding between the hermetic sealing lid member and the electronic component housing member, the hermetic sealing lid member and the electronic component housing member can be braze-bonded to each other by the melted silver brazing layer. Thus, the thermal stress caused by the difference in thermal expansion between the hermetic sealing lid member and the electronic component housing member can be sufficiently reduced.

In this case, the silver brazing layer preferably contains Sn in addition to Ag and Cu. According to this structure, the melting point of the silver brazing layer can be further reduced, and hence the thermal stress caused by the difference in thermal expansion between the hermetic sealing lid member and the electronic component housing member can be further reduced.

In the aforementioned hermetic sealing lid member according to the first aspect, the clad material preferably further includes a surface layer bonded to a surface of the base material layer on a side opposite to the electronic component housing member and made of Ni or a Ni alloy. According to this structure, the corrosion of the base material layer on the surface on the side opposite to the electronic component housing member can be more reliably suppressed by the surface layer made of Ni or the Ni alloy. Furthermore, when the hermetic sealing lid member and the electronic component housing member are braze-bonded to each other by seam welding, a contact resistance between the hermetic sealing lid member and a roller electrode can be reduced by the surface layer made of Ni or the Ni alloy, and hence occurrence of spark or the like between the hermetic sealing lid member and the roller electrode can be suppressed.

An electronic component housing package according to a second aspect of the present invention includes an electronic component housing member for housing an electronic component, and a hermetic sealing lid member made of a clad material including a base material layer made of an Fe alloy that contains 4 mass% or more of Cr, and a silver brazing layer bonded onto one surface of the base material layer on a side closer to the electronic component housing member through an intermediate layer made of Cu or bonded in direct contact with the surface of the base material layer on the side closer to the electronic component housing member, and bonded to the electronic component housing member through the silver brazing layer.

The electronic component housing package according to the second aspect of the present invention uses the hermetic sealing lid member according to the aforementioned first aspect in which the corrosion of the base material layer is suppressed such that the degradation of the hermetic sealing lid member caused by the corrosion can be suppressed, and hence a reduction in the hermetic sealability of the electronic component housing package using the hermetic sealing lid member can be suppressed. Furthermore, the hermetic sealing lid member is provided with the silver brazing layer bonded to one surface of the base material layer on the side closer to the electronic component housing member through the intermediate layer made of Cu or bonded in direct contact with one surface of the base material layer on the side closer to the electronic component housing member such that the electronic component housing package in which the hermetic sealing lid member is directly braze-bonded to the electronic component housing member without using a seal ring can be obtained.

In the aforementioned electronic component housing package according to the second aspect, the base material layer is preferably made of the Fe alloy that contains 4 mass% or more and 20 mass% or less of Cr. According to this structure, an increase in the thermal expansion coefficient of the base material layer caused by an increase in the content percentage of Cr over about 20 mass% can be suppressed. Thus, an increase in a difference in thermal expansion between the electronic component housing member made of a low thermal expansion material such as ceramics and the hermetic sealing lid member can be suppressed. Consequently, a thermal stress generated between the hermetic sealing lid member and the electronic component housing member can be reduced, and hence a reduction in the hermetic sealability of the electronic component housing package caused by the thermal stress can be suppressed.

In the aforementioned electronic component housing package according to the second aspect, the base material layer is preferably made of the Fe alloy that further contains Ni in addition to 4 mass% or more of Cr. According to this structure, an increase in the thermal expansion coefficient of the base material layer can be suppressed by containing Ni in the Fe alloy of the base material layer while the sufficient corrosion resistance of the base material layer is ensured by setting the content percentage of Cr of the base material layer to 4 mass% or more.

In this case, the base material layer is preferably made of the Fe alloy that further contains Co in addition to 4 mass% or more of Cr and Ni. According to this structure, an increase in the thermal expansion coefficient of the base material layer can be effectively suppressed by containing not only Ni but also Co in the Fe alloy of which the base material layer is made.

In the aforementioned electronic component housing package according to the second aspect, the clad material preferably further includes a surface layer bonded to a surface of the base material layer on a side opposite to the electronic component housing member and made of Ni or a Ni alloy. According to this structure, the corrosion of the base material layer on the surface on the side opposite to the electronic component housing member can be more reliably suppressed by the surface layer made of Ni or the Ni alloy. Furthermore, when the hermetic sealing lid member and the electronic component housing member are braze-bonded to each other by seam welding, a contact resistance between the hermetic sealing lid member and a roller electrode can be reduced by the surface layer made of Ni or the Ni alloy, and hence occurrence of spark or the like between the hermetic sealing lid member and the roller electrode can be suppressed.

### Effect of the Invention

According to the present invention, as hereinabove described, the hermetic sealing lid member capable of being directly braze-bonded to the electronic component housing member without using the seal ring, in which the corrosion of the base material layer can be suppressed, and the electronic component housing package using the hermetic sealing lid member.

### Brief Description of the Drawings

[Fig. 1] A plan view showing the structure of a hermetic sealing lid member according to a first embodiment of the present invention.
[Fig. 2] A sectional view taken along the line 300-300 in Fig. 1.
[Fig. 3] A sectional view showing the structure of an electronic component housing package according to the first embodiment of the present invention.
[Fig. 4] A sectional view showing the layer structure of a hermetic sealing lid member according to a modification of the first embodiment of the present invention.
[Fig. 5] A sectional view showing the layer structure of a hermetic sealing lid member according to a second embodiment of the present invention.
[Fig. 6] A table showing the results of a corrosion resistance test of a base material layer of a hermetic sealing lid member conducted in order to confirm the effect of the present invention.
[Fig. 7] A table showing the average thermal expansion coefficient of a base material layer of a hermetic sealing lid member conducted in order to confirm the effect of the present invention.

### Modes for Carrying Out the Invention

Embodiments embodying the present invention are hereinafter described on the basis of the drawings.

### [First Embodiment]

### (Structure of Hermetic Sealing Lid Member)

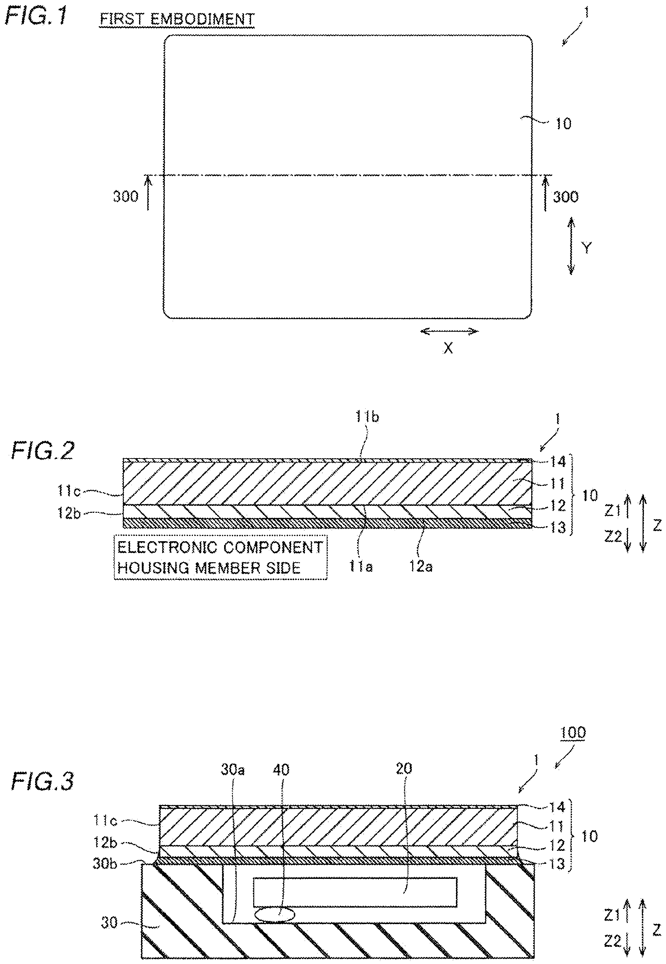

The structure of a hermetic sealing lid member 1 according to a first embodiment of the present invention is now described with reference to Figs. 1 and 2.

The hermetic sealing lid member 1 according to the first embodiment of the present invention is used for an electronic component housing package 100 (see Fig. 3) that includes an electronic component housing member 30 for housing an electronic component 20 described later.

The hermetic sealing lid member 1 is made of a flat plate-shaped clad material 10, as shown in Figs. 1 and 2. Specifically, the hermetic sealing lid member 1 is made of the four-layered clad material that includes a base material layer 11, an intermediate layer 12 bonded in direct contact with the lower surface 11a (a surface on a Z2 side, a surface on a side closer to the electronic component housing member 30) of the base material layer 11, a silver brazing layer 13 bonded in direct contact with the lower surface 12a of the intermediate layer 12, and a surface layer 14 bonded in direct contact with the upper surface 11b (a surface on a Z1 side, a surface on a side opposite to the electronic component housing member 30) of the base material layer 11. No Ni plated layers or the like are provided on side surfaces of the clad material 10, and hence in the clad material 10, side surfaces 11c of the base material layer 11, side surfaces 12b of the intermediate layer 12, the silver brazing layer 13, and the surface layer 14 are exposed outward. The lower surface 11a is an example of a "surface" in the present invention.

The base material layer 11 is a layer to mainly determine parameters such as the mechanical strength and thermal expansion rate of the clad material 10.

According to the first embodiment, the base material layer 11 is made of an Fe alloy that at least contains 4 mass% or more of Cr in order to sufficiently ensure the corrosion resistance. The base material layer 11 contains 4 mass% or more of Cr such that passive films that mainly contain Cr₂O₃ are formed on the exposed side surfaces 11c, and hence the corrosion resistance of the side surfaces 11c of the base material layer 11 is improved. The content percentage of Cr of the Fe alloy of which the base material layer 11 is made is preferably 4 mass% or more and about 20 mass% or less in order to further improve the corrosion resistance, and more preferably about 6 mass% or more and about 10 mass% or less. When the Fe alloy of which the base material layer 11 is made contains neither Ni nor Co described later, the content percentage of Cr of the Fe alloy is preferably about 16 mass% or more and about 20 mass% or less.

The base material layer 11 is preferably made of the Fe alloy that further contains Ni in addition to 4 mass% or more of Cr in order to improve the corrosion resistance and reduce the thermal expansion coefficient. At this time, the content percentage of Ni in the Fe alloy of the base material layer 11 is more preferably about 36 mass% or more and about 48 mass% or less, and still more preferably about 40 mass% or more and about 48 mass% or less. Furthermore, the base material layer 11 is more preferably made of the Fe alloy that further contains Co in addition to 4 mass% or more of Cr and Ni in order to further reduce the thermal expansion coefficient. At this time, the content percentage of Co in the Fe alloy of the base material layer 11 is more preferably about 6 mass% or more and about 18 mass% or less.

The intermediate layer 12 is made of pure Cu such as tough pitch copper or phosphorous-deoxidized copper that contains about 99.90% or more of Cu, or oxygen-free copper that contains about 99.95% or more of Cu. The intermediate layer 12 is preferably made of oxygen-free copper of higher purity. Thus, as compared with the case where the intermediate layer is made of Ni or a Ni alloy, the intermediate layer 12 can be sufficiently softened (low proof strength). Furthermore, the intermediate layer 12 is made of pure Cu, and hence the exposed side surfaces 12b of the intermediate layer 12 each have a sufficient corrosion resistance. The thickness of the intermediate layer 12 in a direction Z is preferably a thickness of about 5 µm or more and about 50 µm or less, and more preferably a thickness of about 10 µm or more and about 30 µm or less in order to relieve a thermal stress described later. Furthermore, the thickness of the intermediate layer 12 is preferably about 30% of the thickness of the clad material 10 in the direction Z.

The silver brazing layer 13 is made of a silver brazing material made of a Ag-Cu alloy that contains Ag, inevitable impurities, and the balance Cu or a Ag-Sn-Cu alloy that contains Ag, Sn, inevitable impurities, and the balance Cu. For example, the silver brazing material is made of a 72Ag-Cu alloy that contains about 72 mass% of Ag, inevitable impurities, and the balance Cu, an 85Ag-Cu alloy that contains about 85 mass% of Ag, inevitable impurities, and the balance Cu, or the like. Furthermore, for example, the silver brazing material is made of a 67Ag-4Sn-Cu alloy that contains about 67 mass% of Ag, about 4 mass% of Sn, inevitable impurities, and the balance Cu and is excellent in workability. The silver brazing layer 13 is made of the Ag-Cu alloy or the Ag-Sn-Cu alloy, and hence the exposed silver brazing layer 13 has a sufficient corrosion resistance. The melting point of the silver brazing material is about 780°C or less. The melting point of the silver brazing material made of the Ag-Sn-Cu alloy is lower than the melting point of the silver brazing material made of the Ag-Cu alloy.

The surface layer 14 is made of pure Ni or a Ni alloy. The surface layer 14 is made of pure Ni or the Ni alloy, and hence the exposed surface layer 14 has a sufficient corrosion resistance. This surface layer 14 has a function of suppressing occurrence of spark or the like between the hermetic sealing lid member 1 and a roller electrode (not shown) by reducing a contact resistance between the hermetic sealing lid member 1 and the roller electrode at the time of direct seam welding described later.

Consequently, any of the side surfaces 11c of the base material layer 11, the side surfaces 12b of the intermediate layer 12, the silver brazing layer 13, and the surface layer 14, all of which are exposed outward in the clad material 10, has a sufficient corrosion resistance, and hence the corrosion of the hermetic sealing lid member 1 is suppressed.

### (Structure of Electronic Component Housing Package)

The structure of the electronic component housing package 100 using the hermetic sealing lid member 1 according to the first embodiment of the present invention is now described with reference to Fig. 3.

The electronic component housing package 100 according to the first embodiment includes the aforementioned hermetic sealing lid member 1 and the electronic component housing member 30 for housing the electronic component 20 such as a crystal unit or a SAW filter (surface acoustic wave filter). In the electronic component housing package 100, the hermetic sealing lid member 1 is arranged on the electronic component housing member 30 such that the silver brazing layer 13 of the hermetic sealing lid member 1 is on the side closer to the electronic component housing member 30 (a lower side, the Z2 side).

The electronic component housing member 30 is made of ceramics (Al₂O₃). Furthermore, the electronic component housing member 30 has a box shape including a recess portion 30a with an opening on an upper side (Z1 side). In the recess portion 30a, the electronic component 20 is fixed through a bump 40.

The hermetic sealing lid member 1 is braze-bonded to the electronic component housing member 30 by being welded (direct seam welded) by seam welding, which is a type of resistance welding, in a state where the hermetic sealing lid member 1 is arranged on the frame-shaped upper surface 30b of the electronic component housing member 30. In other words, the silver brazing material of the silver brazing layer 13 of the hermetic sealing lid member 1 is melted by seam welding, and is bonded onto the upper surface 30b of the electronic component housing member 30. At the time of seam welding, an electric current flows between the surface layer 14 made of Ni or the Ni alloy and the roller electrode (not shown) such that the silver brazing material of the silver brazing layer 13 is melted. Furthermore, the hermetic sealing lid member 1 and the electronic component housing member 30 are directly bonded to each other not through a seal ring.

In order to improve braze bonding between the hermetic sealing lid member 1 and the electronic component housing member 30, a metalization layer may be formed on the upper surface 30b of the electronic component housing member 30. The metalization layer has a structure in which a W layer, a Ni layer, and a Au layer (not shown) are stacked in this order from the upper surface 30b side of the electronic component housing member 30.

Heat for melting the silver brazing layer 13 of the hermetic sealing lid member 1 is applied to the hermetic sealing lid member 1 and the electronic component housing member 30, and both the hermetic sealing lid member 1 and the electronic component housing member 30 are thermally expanded. At this time, a thermal stress caused by a difference in thermal expansion between the hermetic sealing lid member 1 (base material layer 11) and the electronic component housing member 30 is generated. According to the first embodiment, as described above, the intermediate layer 12 made of pure Cu, which is sufficiently soft, is provided such that the intermediate layer 12 is easily plastic-deformed following the deformation of the base material layer 11, and hence the thermal stress generated in the hermetic sealing lid member 1 is relieved. Therefore, according to the aforementioned first embodiment, even when the difference in thermal expansion between the hermetic sealing lid member 1 (base material layer 11) and the electronic component housing member 30 somewhat exists, a reduction in the hermetic sealability of the electronic component housing package 100 can be sufficiently suppressed.

According to the first embodiment, the following effects can be obtained.

According to the first embodiment, as hereinabove described, the base material layer 11 is made of the Fe alloy that at least contains 4 mass% or more of Cr. Thus, the corrosion resistance of the base material layer 11 can be reliably improved, and hence the corrosion of the base material layer 11 can be suppressed even in a harsh environment. Thus, the degradation of the hermetic sealing lid member 1 caused by the corrosion can be suppressed, and hence a reduction in the hermetic sealability of the electronic component housing package 100 using the hermetic sealing lid member 1 can be suppressed. Furthermore, the hermetic sealing lid member 1 can be directly braze-bonded to the electronic component housing member 30 without using a seal ring by the silver brazing layer 13 bonded onto the lower surface 11a of the base material layer 11 on the side closer to the electronic component housing member 30 through the intermediate layer 12 made of Cu.

According to the first embodiment, the base material layer 11 is made of the Fe alloy that contains 4 mass% or more and about 20 mass% or less of Cr such that an increase in the thermal expansion coefficient of the base material layer 11 caused by an increase in the content percentage of Cr over about 20 mass% can be suppressed. Thus, an increase in the difference in thermal expansion between the electronic component housing member 30 made of ceramics and the hermetic sealing lid member 1 can be suppressed. Consequently, the thermal stress generated between the hermetic sealing lid member 1 and the electronic component housing member 30 can be reduced, and hence a reduction in the hermetic sealability of the electronic component housing package 100 caused by the thermal stress can be suppressed.

According to the first embodiment, the base material layer 11 is made of the Fe alloy that contains about 6 mass% or more and about 10 mass% or less of Cr such that the corrosion resistance of the base material layer 11 can be reliably improved, and an increase in the thermal expansion coefficient of the base material layer 11 can be effectively suppressed.

According to the first embodiment, the base material layer 11 is made of the Fe alloy that further contains Ni in addition to 4 mass% or more of Cr such that an increase in the thermal expansion coefficient of the base material layer 11 can be suppressed by containing Ni in the Fe alloy of the base material layer 11 while the sufficient corrosion resistance of the base material layer 11 is ensured by setting the content percentage of Cr of the base material layer 11 to 4 mass% or more.

According to the first embodiment, the base material layer 11 is made of the Fe alloy that further contains about 36 mass% or more and about 48 mass% or less (more preferably about 40 mass% or more and about 48 mass% or less) of Ni in addition to 4 mass% or more of Cu such that an increase in the thermal expansion coefficient of the base material layer 11 can be effectively suppressed by setting the content percentage of Ni of the base material layer 11 to about 36 mass% or more and about 48 mass% or less (more preferably about 40 mass% or more and about 48 mass% or less) while the sufficient corrosion resistance of the base material layer 11 is ensured by setting the content percentage of Cr of the base material layer 11 to 4 mass% or more.

According to the first embodiment, the base material layer 11 is made of the Fe alloy that further contains Co in addition to 4 mass% or more of Cr and Ni such that an increase in the thermal expansion coefficient of the base material layer 11 can be effectively suppressed by containing not only Ni but also Co in the Fe alloy of which the base material layer 11 is made.

According to the first embodiment, the base material layer 11 is made of the Fe alloy that further contains about 6 mass% or more and about 18 mass% or less of Co in addition to 4 mass% or more of Cr and about 36 mass% or more and about 48 mass% or less of Ni such that an increase in the thermal expansion coefficient of the base material layer 11 can be more effectively suppressed.

According to the first embodiment, the base material layer 11 is made of the Cr-Fe alloy that contains neither Ni nor Co and at least contains about 16 mass% or more and about 20 mass% or less of Cr such that the corrosion resistance of the base material layer 11 can be more reliably ensured, and the thermal expansion of the base material layer 11 can be effectively suppressed when the hermetic sealing lid member 1 is arranged in a high-temperature environment of about 400°C or more.

According to the first embodiment, the silver brazing layer 13 is bonded to the base material layer 11 through the intermediate layer 12 made of pure Cu that contains about 99.95 mass% or more of Cu such that the intermediate layer 12 can be sufficiently softened, and hence the thermal stress caused by the difference in thermal expansion between the hermetic sealing lid member 1 and the electronic component housing member 30 can be sufficiently relieved by the soft intermediate layer 12.

According to the first embodiment, the thickness of the intermediate layer 12 in the direction Z is about 5 µm or more (more preferably about 10 µm or more) such that the thickness of the intermediate layer 12 can be sufficiently ensured, and hence the thermal stress caused by the difference in thermal expansion between the hermetic sealing lid member 1 and the electronic component housing member 30 can be sufficiently relieved. Furthermore, the thickness of the intermediate layer 12 in the direction Z is about 50 µm or less (more preferably about 30 µm or less) such that the formation of an excessive amount of the intermediate layer 12 can be suppressed, and hence an increase in the size of the hermetic sealing lid member 1 in a thickness direction (direction Z) can be suppressed.

According to the first embodiment, the silver brazing layer 13 contains Ag and Cu such that the melting point of the silver brazing layer 13 can be reduced, and hence in a state where the temperature rising of the hermetic sealing lid member 1 and the temperature rising of the electronic component housing member 30 are suppressed at the time of braze bonding between the hermetic sealing lid member 1 and the electronic component housing member 30, the hermetic sealing lid member 1 and the electronic component housing member 30 can be braze-bonded to each other by the melted silver brazing layer 13. Thus, the thermal stress caused by the difference in thermal expansion between the hermetic sealing lid member 1 and the electronic component housing member 30 can be sufficiently reduced.

According to the first embodiment, the silver brazing layer 13 contains Sn in addition to Ag and Cu such that the melting point of the silver brazing layer 13 can be further reduced, and hence the thermal stress caused by the difference in thermal expansion between the hermetic sealing lid member 1 and the electronic component housing member 30 can be further reduced.

According to the first embodiment, the surface layer 14 bonded to the upper surface 11b of the base material layer 11 on the side (Z1 side) opposite to the electronic component housing member 30 and made of Ni or the Ni alloy is provided in the clad material 10. Thus, the corrosion of the base material layer 11 on the upper surface 11b can be more reliably suppressed by the surface layer 14 made of Ni or the Ni alloy. Furthermore, when the hermetic sealing lid member 1 and the electronic component housing member 30 are braze-bonded to each other by seam welding, the contact resistance between the hermetic sealing lid member 1 and the roller electrode can be reduced by the surface layer 14 made of Ni or the Ni alloy, and hence occurrence of spark or the like between the hermetic sealing lid member 1 and the roller electrode can be suppressed.

### [Modification of First Embodiment]

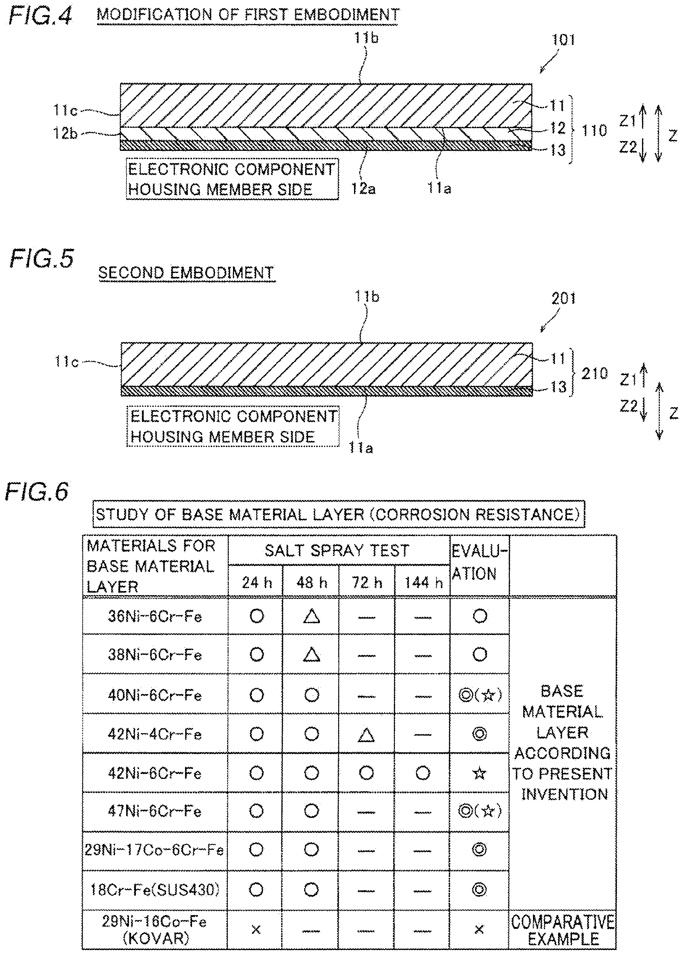

A hermetic sealing lid member 101 according to a modification of the first embodiment of the present invention is now described with reference to Fig. 4. The same structures as those of the first embodiment are denoted by the same reference numerals, to omit the description.

This hermetic sealing lid member 101 according to the modification of the first embodiment is made of a three-layered clad material 110 that includes a base material layer 11 made of an Fe alloy that at least contains 4 mass% or more of Cr, an intermediate layer 12 bonded in direct contact with the lower surface 11a of the base material layer 11, and a silver brazing layer 13 bonded in direct contact with the lower surface 12a of the intermediate layer 12. In other words, no surface layer is formed in the hermetic sealing lid member 101 according to the modification of the first embodiment, unlike the hermetic sealing lid member 1 according to the aforementioned first embodiment.

The melting point of a silver brazing material of which the silver brazing layer 13 is made is about 780°C or less, and hence an excessively high temperature such as about 1000°C or more is not required to melt the silver brazing layer 13. Thus, even when a value of an electric current that flows into a roller electrode is relatively small at the time of seam welding, the silver brazing layer 13 can be melted. In other words, even when the base material layer 11 of the hermetic sealing lid member 101 and the roller electrode (not shown) are brought into direct contact with each other not through a surface layer made of Ni or a Ni alloy, a value of an electric current that flows through the hermetic sealing lid member 101 is reduced such that it is possible to make it unlikely that spark caused by a large contact resistance occurs. As the silver brazing material, a Ag-Sn-Cu alloy having a lower melting point is used such that occurrence of spark can be further suppressed.

Any of side surfaces 11c of the base material layer 11, side surfaces 12b of the intermediate layer 12, and the silver brazing layer 13, all of which are exposed outward in the clad material 110, has a sufficient corrosion resistance such that the corrosion of the hermetic sealing lid member 101 is suppressed.

The remaining structures of the hermetic sealing lid member 101 according to the aforementioned modification of the first embodiment and the structure of an electronic component housing package using the hermetic sealing lid member 101 are substantially similar to those of the aforementioned first embodiment.

According to the modification of the first embodiment, the following effects can be obtained.

According to the modification of the first embodiment, as hereinabove described, the base material layer 11 is made of the Fe alloy that at least contains 4 mass% or more of Cr such that the corrosion of the base material layer 11 can be suppressed similarly to the aforementioned first embodiment.

According to the modification of the first embodiment, no surface layer is formed in the hermetic sealing lid member 101 such that the structure of the clad material 110 can be simplified, and the cost for preparing the clad material 110 can be reduced by providing no surface layer. The effects of the modification of the first embodiment are substantially similar to those of the aforementioned first embodiment.

### [Second Embodiment]

A hermetic sealing lid member 201 according to a second embodiment of the present invention is now described with reference to Fig. 5. The same structures as those of the first embodiment are denoted by the same reference numerals, to omit the description.

This hermetic sealing lid member 201 according to the second embodiment is made of a two-layered clad material 210 that includes a base material layer 11 made of an Fe alloy that at least contains 4 mass% or more of Cr and a silver brazing layer 13 bonded in direct contact with the lower surface 11a of the base material layer 11 on a side closer to an electronic component housing member 30. In other words, neither an intermediate layer nor a surface layer is formed in the hermetic sealing lid member 201 according to the second embodiment, unlike the hermetic sealing lid member 1 according to the aforementioned first embodiment. In the hermetic sealing lid member 201 according to the second embodiment, no intermediate layer for relieving a thermal stress is provided, and hence the base material layer 11 having a small thermal expansion coefficient is preferably used such that a difference in thermal expansion between the hermetic sealing lid member 201 (base material layer 11) and the electronic component housing member (see Fig. 3) is reduced.

Any of side surfaces 11c of the base material layer 11 and the silver brazing layer 13, all of which are exposed outward in the clad material 210, has a sufficient corrosion resistance such that the corrosion of the hermetic sealing lid member 201 is suppressed.

The remaining structures of the hermetic sealing lid member 201 according to the aforementioned second embodiment and the structure of an electronic component housing package using the hermetic sealing lid member 201 are substantially similar to those of the aforementioned first embodiment.

According to the second embodiment, the following effects can be obtained.

According to the second embodiment, as hereinabove described, the base material layer 11 is made of the Fe alloy that at least contains 4 mass% or more of Cr such that the corrosion of the base material layer 11 can be suppressed similarly to the aforementioned first embodiment. Furthermore, the hermetic sealing lid member 201 can be directly braze-bonded to the electronic component housing member not through a seal ring by the silver brazing layer 13 directly bonded onto the lower surface 11a of the base material layer 11 on the side closer to the electronic component housing member.

According to the second embodiment, neither an intermediate layer nor a surface layer is formed in the hermetic sealing lid member 201 such that the structure of the clad material 210 can be further simplified. The remaining effects of the second embodiment are substantially similar to those of the aforementioned first embodiment.

### [Examples]

A study of a base material layer used for a hermetic sealing lid member, conducted in order to confirm the effects of the aforementioned embodiments is now described with reference to Figs. 2 and 4 to 7.

### (Compositions of Examples and Comparative Example)

As test materials (metal plates) of which a base material layer 11 (see Figs. 2, 4, and 5) of a hermetic sealing lid member 1 (101, 201) is made, each of which has a corrosion resistance, six types of Ni-Cr-Fe alloy, one type of Ni-Co-Cr-Fe alloy, and one type of Cr-Fe alloy were used.

As the Ni-Cr-Fe alloys, five types of Ni-Cr-Fe alloy that contain Ni, 6 mass% of Cr, inevitable impurities, and the balance Fe, in which the content percentages of Ni are different from each other, were used. Specifically, a 36Ni-6Cr-Fe alloy that contains 36 mass% of Ni, a 38Ni-6Cr-Fe alloy that contains 38 mass% of Ni, a 40Ni-6Cr-Fe alloy that contains 40 mass% of Ni, a 42Ni-6Cr-Fe alloy that contains 42 mass% of Ni, and a 47Ni-6Cr-Fe alloy that contains 47 mass% of Ni were used. Furthermore, as the Ni-Cr-Fe alloy, a 42Ni-4Cr-Fe alloy that contains 42 mass% of Ni, 4 mass% of Cr, inevitable impurities, and the balance Fe was further used.

As the Ni-Co-Cr-Fe alloy, a 29Ni-17Co-6Cr-Fe alloy that contains 29 mass% of Ni, 17 mass% of Co, 6 mass% of Cr, inevitable impurities, and the balance Fe was used. As the Cr-Fe alloy, an 18Cr-Fe alloy (so-called SUS430) that contains 18 mass% of Cr, inevitable impurities, and the balance Fe was used.

On the other hand, as a test material (metal plate) according to Comparative Example, a Ni-Co-Fe alloy that contains no Cr was used. Specifically, a 29Ni-17Co-Fe alloy (co-called kovar) that contains 29 mass% of Ni, 17 mass% of Co, inevitable impurities, and the balance Fe was used.

### (Study of Base Material Layer Based on Corrosion Resistance)

First, as a corrosion resistance test, a salt spray test was conducted on each of the test materials for at least 48 hours at a temperature of 35±2°C, a salt concentration of 5±1 mass%, and a pH of 6.5 or more and 7.2 or less according to JIS C60068-2-11. Then, the degree of corrosion of each of the test materials was observed. The corrosion resistance was evaluated after a lapse of 24 hours and after a lapse of 48 hours. Furthermore, the corrosion resistance of the test material of the 42Ni-4Cr-Fe alloy after a lapse of 72 hours was also evaluated. Furthermore, the corrosion resistance of the test material of the 42Ni-6Cr-Fe alloy after a lapse of 72 hours and after a lapse of 144 hours was also evaluated.

As evaluations of the corrosion resistance, × marks (cross marks) were put on test materials on which significant corrosion was confirmed. On the other hand, Δ marks (triangle mark) were put on test materials on which slight corrosion was confirmed but did not cause a practical problem, and ○ marks (circle marks) were put on test materials on which no corrosion was confirmable. Referring to the results, 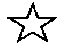 marks (star marks) were put on materials for the base material layer that were evaluated to be particularly suitable in practice, ⊚ marks (double circle marks) were put on materials for the base material layer that were evaluated to be preferable in practice, ○ marks (circle marks) were put on materials for the base material layer that were evaluated to be usable in practice, and × marks (cross marks) were put on materials for the base material layer that were evaluated to be unsuitable in practice.

The results of the salt spray test were that on any of the Fe alloys that contain 4 mass% or more of Cr, corrosion was hardly confirmed after a lapse of 24 hours regardless of whether or not Ni is contained, as shown in Fig. 6. On the other hand, on the Fe alloy (29Ni-17Co-Fe alloy) according to Comparative Example that contains no Cr, significant corrosion was confirmed after a lapse of 24 hours. From these, the Fe alloys that contain 4 mass% or more of Cr could be confirmed to have a sufficient corrosion resistance. Consequently, it has been confirmable that the corrosion of a hermetic sealing lid member made of a clad material can be suppressed by preparing the clad material with the base material layer made of the Fe alloy that contains 4 mass% or more of Cr and an intermediate layer, a surface layer, and a silver brazing layer, each of which has a sufficient corrosion resistance.

On the 36Ni-6Cr-Fe alloy and the 38Ni-6Cr-Fe alloy, slight corrosion was confirmed after a lapse of 48 hours. Thus, it has been proved that of the content percentages of Fe and Ni of the Fe alloy of which the base material layer is made, the content percentage of Ni is increased such that the corrosion of the Fe alloy can be more reliably suppressed, and the corrosion resistance is improved.

On the 42Ni-4Cr-Fe alloy, slight corrosion was confirmed after a lapse of 72 hours. On the other hand, on the 42Ni-6Cr-Fe alloy, corrosion was hardly confirmed even after a lapse of 144 hours. Thus, it has been proved that the content of Cr of the Fe alloy of which the base material layer is made is set to 6 mass% or more such that the corrosion can be still more reliably suppressed, and the corrosion resistance is improved.

Therefore, an Fe alloy in which the content of Cr is 6 mass% or more and the content of Ni is 40 mass% or more is conceivably particularly suitable as the Fe alloy of which the base material layer is made in terms of corrosion resistance. Although no salt spray test for at least 48 hours is conducted on the 40Ni-6Cr-Fe alloy and the 47Ni-6Cr-Fe alloy, the 40Ni-6Cr-Fe alloy and the 47Ni-6Cr-Fe alloy each conceivably have a corrosion resistance capable of sufficiently suppressing corrosion for a long time exceeding 48 hours.

On the 18Cr-Fe alloy that contains no Ni, corrosion was hardly confirmed even after a lapse of 48 hours. Thus, it has been proved that even when the Cr-Fe alloy that contains no Ni is used for the base material layer, the content of Cr of the Fe alloy of which the base material layer is made is increased such that the corrosion can be more reliably suppressed, and the corrosion resistance is improved. Also on a Cr-Fe alloy (SUS430J1L) that contains about 16 mass% or more and about 20 mass% or less of Cr and small amounts of Cu, Nb, etc., the result of the corrosion resistance similar to that of the 18Cr-Fe alloy (SUS430) is conceivably obtained.

### (Study of Base Material Layer Based on Thermal Expansibility)

Next, metal suitable for the base material layer according to the present invention was studied based on the average thermal expansion coefficients of the above test materials. An Fe alloy having a thermal expansion coefficient close to the thermal expansion coefficient of alumina (Al₂O₃) of which an object to be braze-bonded (electronic component housing member 30 in Fig. 3) is made is conceivably more suitable for the base material layer.

Specifically, an average thermal expansion coefficient in a temperature range of 30°C to 300°C, an average thermal expansion coefficient in a temperature range of 30°C to 400°C, and an average thermal expansion coefficient in a temperature range of 30°C to 500°C were determined for each of the test materials. For the alumina of a reference example, only an average thermal expansion coefficient in a temperature range of 30°C to 400°C was determined.

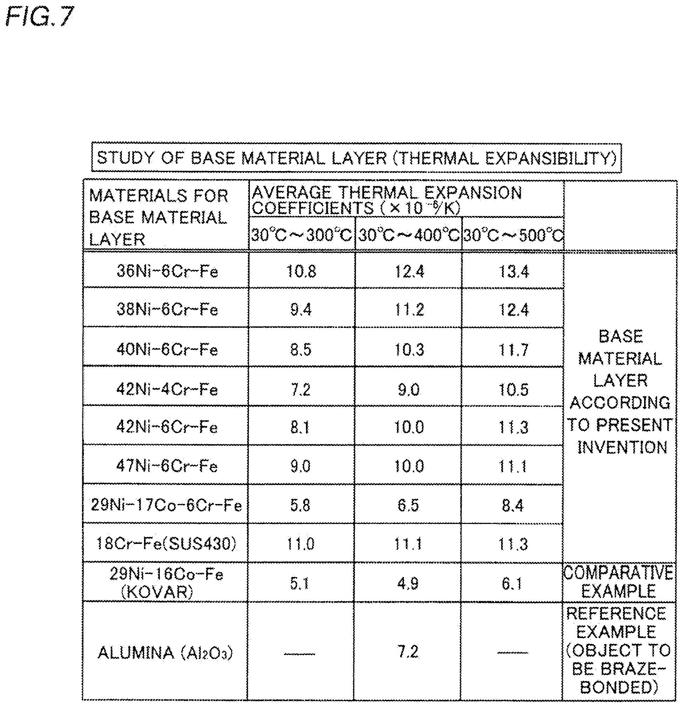

It has been confirmable from a table shown in Fig. 7 that the thermal expansion coefficient of the Fe alloy that contains 4 mass% or more of Cr is 14 × 10⁻⁶/K or less and can be sufficiently reduced in all the temperature ranges of 30°C to 300°C, 30°C to 400°C, and 30°C to 500°C.

Furthermore, it has been proved that the thermal expansion coefficient of the Ni-Co-Cr-Fe alloy (29Ni-17Co-6Cr-Fe alloy) that contains Co is larger than the thermal expansion coefficient of the 29Ni-17Co-Fe alloy that contains no Cr, but is 8.5 × 10⁻⁶/K or less in all the temperature ranges and is smaller than the thermal expansion coefficients of the Ni-Cr-Fe alloys and the Cr-Fe alloy. In addition, the thermal expansion coefficient of the Ni-Co-Cr-Fe alloy became a thermal expansion coefficient closest to the thermal expansion coefficient of the alumina. From these, it has been proved that the Ni-Co-Cr-Fe alloy is most preferable as low thermal expansion metal of which the base material layer of the hermetic sealing lid member is made in terms of thermal expansibility. This Ni-Co-Cr-Fe alloy is conceivably particularly suitable for the base material layer 11 of the clad material 210 according to the aforementioned second embodiment in which no intermediate layer for relieving a thermal stress is provided.

The thermal expansion coefficients of the Ni-Cr-Fe alloys were relatively increased in the temperature range of 30°C to 500°C, but were reduced to 11 × 10⁻⁶/K or less in the temperature range of 30°C to 300°C. Consequently, it has been proved that the Ni-Cr-Fe alloys are also preferable for the base material layer of the hermetic sealing lid member mainly arranged in a low temperature environment of about 300°C or less. It has been proved that when the content percentages of Ni contained in the Ni-Cr-Fe alloys are 40 mass% or more and 47 mass% or less, the thermal expansion coefficients can be further reduced in all the temperature ranges such that the Ni-Cr-Fe alloys that contain 40 mass% or more and 47 mass% or less of Ni are more preferable, and when the content percentages of Ni are in the vicinity of 42 mass%, the thermal expansion coefficients can be still further reduced in all the temperature ranges such that the Ni-Cr-Fe alloys that contain about 42 mass% of Ni are still more preferable. Furthermore, it has been proved that when the content percentages of Cr contained in the Ni-Cr-Fe alloys are less than 6 mass%, the thermal expansion coefficients can be further reduced such that the Ni-Cr-Fe alloys that contain less than 6 mass% of Cr are more preferable.

The thermal expansion coefficient of the Cr-Fe alloy (18Cr-Fe alloy) was increased to some extent in all the temperature ranges, but variations in thermal expansion coefficient caused by temperature changes were small. Particularly in the temperature range of 30°C to 500°C, the thermal expansion coefficient of the Cr-Fe alloy was 11.3 × 10⁻⁶/K, and became smaller than the thermal expansion coefficients of the (36 to 40 and 47)Ni-6Cr-Fe alloys. From this, it has been proved that the Cr-Fe alloy is also preferable for the base material layer of the hermetic sealing lid member arranged particularly in a high temperature environment of about 400°C or more. The thermal expansion coefficient of SUS430J1L is similar to that of the 18Cr-Fe alloy (SUS430), and hence SUS430J1L is also conceivably preferable for the base material layer of the hermetic sealing lid member arranged particularly in the high temperature environment of about 400°C or more.

### [Modifications]

The embodiments and Examples disclosed this time must be considered as illustrative in all points and not restrictive. The range of the present invention is shown not by the above description of the embodiments and Examples but by the scope of claims for patent, and all modifications within the meaning and range equivalent to the scope of claims for patent are further included.

For example, while the examples in which the hermetic sealing lid members 1, 101, and 201 are made of the four-layered clad material 10, the three-layered clad material 110, and the two-layered clad material 210, respectively have been shown in the aforementioned first embodiment, the aforementioned modification of the first embodiment, and the aforementioned second embodiment, the present invention is not restricted to this. According to the present invention, the hermetic sealing lid member may be made of a five- or more-layered clad material by providing two or more intermediate layers, for example.

While the example in which the hermetic sealing lid member 1 and the electronic component housing member 30 are bonded to each other by seam welding, which is a type of resistance welding, has been shown in the aforementioned first embodiment, the present invention is not restricted to this. The hermetic sealing lid member and the electronic component housing member may be bonded to each other by resistance spot welding, which is a type of resistance welding, for example. Alternatively, the hermetic sealing lid member and the electronic component housing member may be bonded to each other by a bonding method other than resistance welding. The hermetic sealing lid member and the electronic component housing member may be bonded to each other by electron beam welding using an electron beam, for example.

### Description of Reference Numerals

1, 101, 201: hermetic sealing lid member
10, 110, 210: clad material
11: base material layer
11a: lower surface (surface)
12: intermediate layer
13: silver brazing layer
14: surface layer
20: electronic component
30: electronic component housing member
100: electronic component housing package

## Claims

1. A hermetic sealing lid member (1) used for an electronic component housing package (100) including an electronic component housing member (30) for housing an electronic component (20),
the hermetic sealing lid member made of a clad material (10) comprising:
a base material layer (11) made of an Fe alloy that contains 4 mass% or more of Cr; and
a silver brazing layer (13) bonded onto a surface of the base material layer on a side closer to the electronic component housing member through an intermediate layer (12) or bonded in direct contact with the surface of the base material layer on the side closer to the electronic component housing member.

2. The hermetic sealing lid member according to claim 1, wherein
the base material layer is made of the Fe alloy that contains 4 mass% or more and 20 mass% or less of Cr.

3. The hermetic sealing lid member according to claim 2, wherein
the base material layer is made of the Fe alloy that contains 6 mass% or more and 10 mass% or less of Cr.

4. The hermetic sealing lid member according to any one of claims 1 to 3, wherein
the base material layer is made of the Fe alloy that further contains Ni in addition to 4 mass% or more of Cr.

5. The hermetic sealing lid member according to claim 4, wherein
the base material layer is made of the Fe alloy that further contains 36 mass% or more and 48 mass% or less of Ni in addition to 4 mass% or more of Cr.

6. The hermetic sealing lid member according to claim 5, wherein
the base material layer is made of the Fe alloy that further contains 40 mass% or more and 48 mass% or less of Ni in addition to 4 mass% or more of Cr.

7. The hermetic sealing lid member according to claim 4, wherein
the base material layer is made of the Fe alloy that further contains Co in addition to 4 mass% or more of Cr and Ni.

8. The hermetic sealing lid member according to claim 7, wherein
the base material layer is made of the Fe alloy that further contains 6 mass% or more and 18 mass% or less of Co in addition to 4 mass% or more of Cr and 36 mass% or more and 48 mass% or less of Ni.

9. The hermetic sealing lid member according to any one of claims 1 to 3, wherein
the base material layer is made of a Cr-Fe alloy that contains neither Ni nor Co and at least contains 16 mass% or more and 20 mass% or less of Cr.

10. The hermetic sealing lid member according to any one of claims 1 to 3, wherein
the silver brazing layer is bonded to the base material layer through the intermediate layer made of pure Cu that contains 99.95 mass% or more of Cu.

11. The hermetic sealing lid member according to any one of claims 1 to 3, wherein
a thickness of the intermediate layer is 5 µm or more and 50 µm or less.

12. The hermetic sealing lid member according to claim 11, wherein
the thickness of the intermediate layer is 10 µm or more and 30 µm or less.

13. The hermetic sealing lid member according to any one of claims 1 to 3, wherein
the silver brazing layer contains Ag and Cu.

14. The hermetic sealing lid member according to claim 13, wherein
the silver brazing layer contains Sn in addition to Ag and Cu.

15. The hermetic sealing lid member according to any one of claims 1 to 3, wherein
the clad material further comprises a surface layer (14) bonded to a surface of the base material layer on a side opposite to the electronic component housing member and made of Ni or a Ni alloy.

16. An electronic component housing package (100) comprising:
an electronic component housing member (30) for housing an electronic component (20); and
a hermetic sealing lid member (1) made of a clad material (10) comprising a base material layer (11) made of an Fe alloy that contains 4 mass% or more of Cr, and a silver brazing layer (13) bonded onto a surface of the base material layer on a side closer to the electronic component housing member through an intermediate layer (12) or bonded in direct contact with the surface of the base material layer on the side closer to the electronic component housing member, the hermetic sealing lid member bonded to the electronic component housing member through the silver brazing layer.

17. The electronic component housing package according to claim 16, wherein
the base material layer is made of the Fe alloy that contains 4 mass% or more and 20 mass% or less of Cr.

18. The electronic component housing package according to claim 16 or 17, wherein
the base material layer is made of the Fe alloy that further contains Ni in addition to 4 mass% or more of Cr.

19. The electronic component housing package according to claim 18, wherein
the base material layer is made of the Fe alloy that further contains Co in addition to 4 mass% or more of Cr and Ni.

20. The electronic component housing package according to claim 16 or 17, wherein
the clad material further comprises a surface layer (14) bonded to a surface of the base material layer on a side opposite to the electronic component housing member and made of Ni or a Ni alloy.
